# EUROPÄISCHE PATENTSCHRIFT

(11) **EP 1 344 225 B1**
(45) Veröffentlichungstag und Bekanntmachung des Hinweises auf die Patenterteilung: **03.08.2005**
(21) Anmeldenummer: 01271638.7
(22) Anmeldetag: 04.12.2001
(51) Int. Cl.: G11C 29/00

(54) **SCHALTUNGSANORDUNG ZUR ANSTEUERUNG EINER PROGRAMMIERBAREN VERBINDUNG**
CIRCUIT ARRANGEMENT FOR CONTROLLING A PROGRAMMABLE CONNECTION
CIRCUIT DESTINE A LA COMMANDE D'UNE LIAISON PROGRAMMABLE

(30) Priorität: 20.12.2000 DE 10063688
(43) Veröffentlichungstag der Anmeldung: 17.09.2003
(73) Patentinhaber: Infineon Technologies AG, 81669 München (DE)
(72) Erfinder: KAISER, Robert, 86916 Kaufering (DE); SCHAMBERGER, Florian, 83435 Bad Reichenhall (DE)
(74) Vertreter: Epping, Hermann, Fischer
(86) Internationale Anmeldenummer: PCT/DE2001/004540
(87) Internationale Veröffentlichungsnummer: WO 2002/050841

(56) Entgegenhaltungen:
- EP-A- 0 805 451
- WO-A-01/41150
- US-A- 5 668 818

## Beschreibung

Die vorliegende Erfindung betrifft eine Schaltungsanordnung mit einer Vorrichtung zur Ansteuerung einer programmierbaren Verbindung sowie deren Verwendung in einem Speicherchip.

In Speicherchips, beispielsweise SD-RAMs (Synchronous Dynamic Random Access Memory), welche beispielsweise einen Speicherplatz von 256 Megabit aufweisen, sind üblicherweise zur Bereitstellung einer Redundanz Speicherzellen vorgesehen, welche fertigungsbedingte Ausfälle einzelner Speicherzellen ausgleichen können. Hierzu sind programmierbare Verbindungen, die auch als Fuses bezeichnet werden, vorgesehen, mit denen ein Ersetzen von defekten Speicherzellen mit intakten Ersatzzellen ermöglicht ist. Beispielsweise bei 256 MegaBit-RAMs sind einige tausend Fuses vorgesehen.

Die Fuses können in bekannter Weise entweder mit einem Energleimpuls in Form eines Lasers oder durch einen elektrischen Impuls, beispielsweise einen Spannungs- oder einen Stromimpuls, dauerhaft bezüglich ihres Leitzustandes umprogrammiert werden. Dabei unterscheidet man die sogenannten Fuses, welche mit dem beschriebenen Energieimpuls von einem leitenden (niederohmigen) in einen nichtleitenden (hochohmigen) Zustand versetzt werden können, und Antifuses, welche durch Beaufschlagen mit einem Energieimpuls von einem nichtleitenden in einen leitenden Zustand gebracht werden können.

Das sogenannte Programmieren, Aktivieren, Brennen oder Schießen von Fuses, welches ein einmaliger Vorgang ist, mit dem die Fuse dauerhaft von einem niederohmigen in einen hochohmigen oder von einem hochohmigen in einen niederohmigen Zustand gebracht wird, erfolgt bei Halbleiterspeicherchips bisher üblicherweise mittels Laser vor einem Vergießen des Speicherchips. Damit ist jedoch der Nachteil verbunden, daß keine Reparatur defekter Speicherzellen nach Vergießen des Chips mehr möglich ist.

Weiterhin ist es üblich, die Speicherzellen einer ganzen Wortleitung in einem Speicherchip zu ersetzen, wünschenswert ist jedoch das Ersetzen einzelner Adressen von Speicherzellen, das sogenannte Single Address Repair.

Bei einem Brennen von Fuses mittels Strom- oder Spannungsimpulsen, welches prinzipiell auch nach Vergießen eines Chips möglich ist, kann das Problem auftreten, daß das gleichzeitige Brennen mehrerer Fuses eine unzulässig hohe Stromaufnahme der Schaltung mit sich bringt.

In einem Massen-Speicherchip ist es normalerweise einerseits wünschenswert, ein Ersetzen defekter Speicherzellen durch redundante, intakte Speicherzellen in Echtzeit zu programmieren, da bei heutigen Speicherchip-Taktraten von über 100 MHz ein Brennen von Fuses innerhalb einer Taktperiode, das heißt vor dem nächsten potentiellen Zugriff auf die reparierte Speicherzelle, nicht möglich ist. Andererseits sind derart schnelle Speicher üblicherweise flüchtige Speicher, folglich ist zusätzlich ein dauerhaftes Programmieren einer Fuse erforderlich.

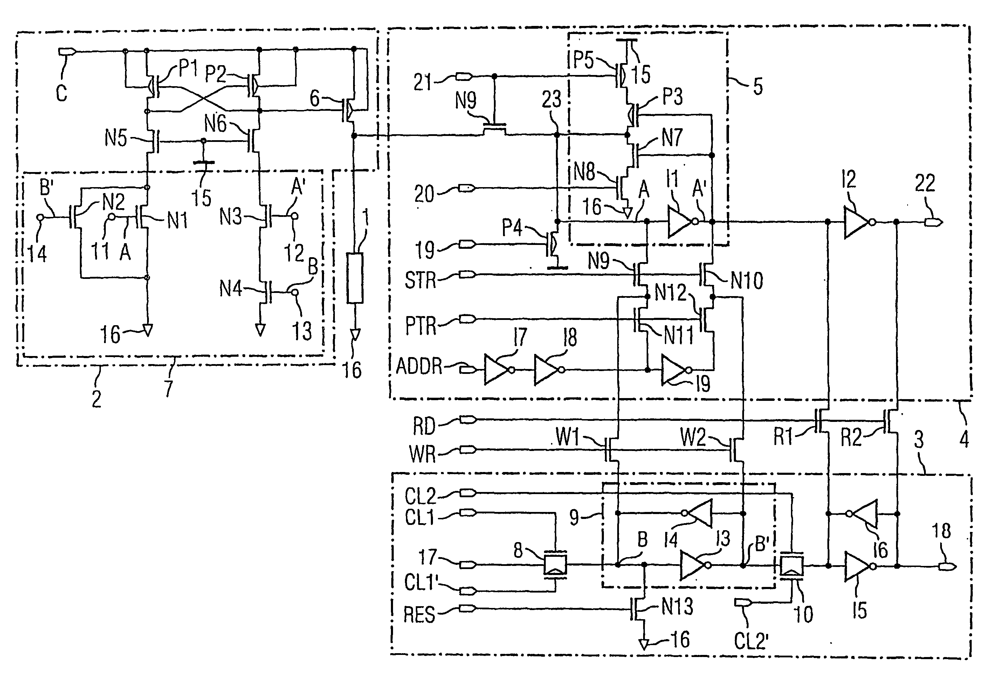

Ein Speichersystem mit elektrisch programmierbaren Fuses sowie einem Schreibregiste, zum Auslesen der Fuses ist aus der EP 0 805 451 Cs, insbesondere die Figur 1 und Spalte 4, Zeilen 5-20) bekannt.

Aufgabe der vorliegenden Erfindung ist es, eine Schaltungsanordnung zur Ansteuerung einer programmierbaren Verbindung, insbesondere mittels eines Energieimpulses, anzugeben, bei der ein schnelles Auslesen und Beschreiben von mit der Ansteuerschaltung für die programmierbare Verbindung gekoppelten flüchtigen Speichern ermöglicht ist.

Erfindungsgemäß wird die Aufgabe gelöst mit einer Schaltungsanordnung zur Ansteuerung einer programmierbaren Verbindung, aufweisend
- eine flüchtige Speicherzelle, die mit einem Adreß-Eingang zur Zuführung einer Adreß-Information verbunden ist,
- die programmierbare Verbindung, die mit dem flüchtigen Speicher zur permanenten Speicherung eines Datums aus der flüchtigen Speicherzelle gekoppelt ist und
- ein Schieberegister mit einer Registerzelle, welches mit der flüchtigen Speicherzelle zum einen in einer Leserichtung und zum anderen in einer Schreibrichtung zur Datenübertragung zwischen Registerzelle und Speicherzelle gekoppelt ist.

Die programmierbaren Verbindung kann als Fuse oder als Antifuse ausgebildet sein.

Eine als Fuse ausgebildete programmierbare Verbindung geht bei Beaufschlagen mit einem Energieimpuls von einem niederohmigen in einen hochohmigen Leitzustand über. Eine als Antifuse ausgebildete programmierbare Verbindung geht bei Beaufschlagen mit einem Energieimpuls von einem hochohmigen in einen niederohmigen Leitzustand über. Der Übergang von einem Leitzustand in einen anderen ist dabei in beiden Fällen normalerweise ein irreversibler Vorgang.

Zum Adressieren einer fehlerhaften Speicherzelle eines SD-RAM oder eines anderen Speicherbausteins können beispielsweise mehrere Bit vorgesehen sein, von denen für jedes eine beschriebene Schaltungsanordnung vorgesehen ist. Die jeweiligen Schieberegister können dabei zur Bildung einer Schieberegisterkette seriell miteinander verbunden sein. Das heißt, daß ein Eingang eines Schieberegisters an einen Ausgang eines anderen Schieberegisters angeschlossen sein kann. Mit dem Schieberegister, welches in einer Leserichtung und in einer Schreibrichtung mit der Registerzelle des Schieberegisters gekoppelt ist, ist es möglich, die Speicherzellen der jeweiligen flüchtigen Speicher, welche jeweils einer Programmierbaren Verbindung zugeordnet sind, seriell auszulesen und zu beschreiben. Hierfür ist ein besonders geringer Schaltungsaufwand erforderlich. Das Schreiben und Lesen kann mit der beschriebenen Schaltungsanordnung besonders schnell erfolgen.

Mit der programmierbaren Verbindung wird die in der flüchtigen Speicherzelle vorübergehend gespeicherte Information permanent gespeichert. Mit dem beschriebenen Schieberegister werden beispielsweise die dauerhaft zu speichernden Informationen in die jeweiligen Speicherzellen der zugeordneten programmierbaren Verbindungen geschrieben. Weiterhin ermöglicht die beschriebene Schaltungsanordnung ein schnelles Auslesen der in den programmierbaren Verbindungen gespeicherten Informationen über den flüchtigen Speicher, der mit der programmierbaren Verbindung zu deren Auslesen gekoppelt ist, sowie mittels des Schieberegisters oder einer aus mehreren Schieberegistern gebildeten Schieberegisterkette.

In der Speicherzelle des flüchtigen Speichers kann beispielsweise ein Bit einer Adresse einer defekten, zu reparierenden Speicherzelle eines SD-RAM gespeichert sein.

Die Kopplung zwischen flüchtigem Speicher und programmierbarer Verbindung zur permanenten Speicherung eines Datums aus der Speicherzelle des flüchtigen Speichers kann beispielsweise mittels einer Ansteuerschaltung erfolgen, welche einen zum Brennen oder Programmieren der programmierbaren Verbindung (Fuse) erforderlichen Energieimpuls bereitstellt. Unter der Leserichtung wird dabei die Datenübertragung von der Speicherzelle oder einem Ausgang der Speicherzelle des flüchtigen Speichers in das Schieberegister verstanden. Unter der Schreibrichtung wird dabei die Datenübertragung von der Registerzelle des Schieberegisters zur Speicherzelle oder einem Eingang der Speicherzelle des flüchtigen Speichers verstanden.

In einer bevorzugten Ausführungsform der vorliegenden Erfindung ist ein Schreibtransistor vorgesehen, der mit seinem Steuereingang mit einem Schreibeingang verbunden ist und der mit seiner gesteuerten Strecke die Registerzelle mit der Speicherzelle koppelt, und es ist ein Lesetransistor vorgesehen, der mit seinem Steuereingang an einen Lese-Eingang angeschlossen ist und der mit seiner gesteuerten Strecke einen Ausgang der Speicherzelle mit dem Schieberegister koppelt.

In einer weiteren, bevorzugten Ausführungsform der Erfindung ist eine Ansteuerschaltung vorgesehen zur Ansteuerung der programmierbaren Verbindung mit einem Energieimpuls, wobei die Ansteuerschaltung mit der Speicherzelle des flüchtigen Speichers zur Übermittlung eines Datensignals gekoppelt ist. Die Ansteuerschaltung ermöglicht ein einfaches Auslesen eines Datums aus dem flüchtigen Speicher und ein Zuführen dieses Datensignals zur Ansteuerschaltung. Je nachdem, ob beispielsweise eine Null oder eine Eins ausgelesen ist, kann mit dem Energieimpuls die Fuse gebrannt beziehungsweise programmiert werden oder nicht.

In einer weiteren, bevorzugten Ausführungsform der Erfindung ist die Ansteuerschaltung zur Steuerung des Energieimpulses mit dem Schieberegister zur Übermittlung eines Aktiviersignals gekoppelt. Neben der Möglichkeit, mit dem Schieberegister die Speicherzelle im flüchtigen Speicher zu beschreiben und auszulesen, kann das Schieberegister zugleich zur Aktivierung eines Brennvorgangs der Fuse verwendet sein. Hiermit ist ein gezieltes Nachschießen von Fuses möglich, welche beispielsweise bei einem ersten Programmierversuch nicht programmiert werden konnten. Zudem kann durch das gezielte Auswählen einzelner oder mehrere programmierbarer Verbindungen zum Brennen mit dem Schieberegister ein unzulässig hoher Brennstrom durch Brennen zu vieler programmierbarer Verbindungen gleichzeitig verhindert werden. Zudem ermöglicht die beschriebene Doppelfunktion des Schieberegisters einen besonders platzsparenden Schaltungsaufbau.

In einer weiteren, bevorzugten Ausführungsform der Erfindung weist die Ansteuerschaltung eine UND-Logik-Schaltung auf, die einen Dateneingang mit einem Aktiviereingang UND-verknüpft und die einen Ausgang aufweist, der mit der programmierbaren Verbindung gekoppelt ist. Die programmierbare Verbindung wird bei der beschriebenen UND-Logik-Schaltung in der Ansteuerschaltung lediglich dann bei Anliegen einer Brennspannung gebrannt, wenn sowohl an einem Aktiviereingang ein Aktiviersignal anliegt als auch an einem Dateneingang ein Datensignal anliegt, welches beispielsweise in der Speicherzelle des flüchtigen Speichers bereitgestellt sein kann.

In einer weiteren, bevorzugten Ausführungsform der vorliegenden Erfindung weist die Ansteuerschaltung einen Brenntransistor auf, der eingangsseitig mit dem flüchtigen Speicher gekoppelt ist und der an einem Ausgang, der mit der programmierbaren Verbindung verbunden ist, einen Energieimpuls bereitstellt. Zur Bereitstellung des Energieimpulses können demnach drei Bedingungen erforderlich sein: Es muß das Datensignal eine logische Eins haben, es muß das Aktiviersignal eine logische Eins haben und es muß am Brenntransistor eine Brennspannung anliegen. Wenn alle drei Bedingungen erfüllt sind, kann die programmierbare Verbindung, welche beispielsweise als Anti-Fuse ausgebildet sein kann, geschossen werden.

In einer weiteren, bevorzugten Ausführungsform der Erfindung weist das Schieberegister eingangsseitig und ausgangsseitig je einen Schalter auf, der zu seiner Steuerung mit je einem Taktsignal-Eingang verbunden ist. Beispielsweise zur Adressierung eines 256 Megabit SD-RAM-Chips können 25 Bit erforderlich sein. Zur Adressierung und Speicherung der Adresse einer fehlerhaften Speicherzelle im SD-RAM-Chip können demnach 25 Schaltungsanordnungen der beschriebenen Art vorgesehen sein. Die Schieberegister können dabei über jeweils eingangsseitig und ausgangsseitig vorgesehene Schalter miteinander zu einer Schieberegisterkette seriell verbunden sein. Dies ermöglicht ein taktgesteuertes Einlesen von Daten in die jeweiligen Speicherzellen der flüchtigen Speicher, ein Auslesen von Daten aus den flüchtigen Speichern mit der Registerkette sowie ein Aktivieren von Ansteuerschaltungen beziehungsweise Brenntransistoren zum Brennen von programmierbaren Verbindungen ebenfalls mittels der Schieberegisterkette.

In einer weiteren, bevorzugten Ausführungsform der Erfindung sind die Schalter im Schieberegister CMOS-Transfergates. Diese ermöglichen eine besonders schnelle, serielle Datenübertragung zum Schreiben und Lesen.

In einer weiteren, bevorzugten Ausführungsform der vorliegenden Erfindung weist das Schieberegister eine weitere Speicherzelle auf, die ausgangsseitig an dem der Registerzelle nachgeschalteten Schalter angeschlossen ist. Die weitere Speicherzelle kann zum Auslesen des flüchtigen Speichers mit dem Ausgang der Speicherzelle des flüchtigen Speichers gekoppelt sein.

In einer weiteren, bevorzugten Ausführungsform der vorliegenden Erfindung ist die Schaltungsanordnung in CMOS-Schaltungstechnik aufgebaut. Hierdurch ist es möglich, die Schaltungsanordnung mit besonders geringem Strombedarf und Flächenbedarf zu realisieren.

Weitere Einzelheiten der Erfindung sind Gegenstand der Unteransprüche.

Die Erfindung wird nachfolgend an einem Ausführungsbeispiel anhand der Zeichnung näher erläutert. Es zeigt:
Die Figur ein Ausführungsbeispiel der vorliegenden Erfindung anhand eines Blockschaltbildes.
Die Figur zeigt eine als Antifuse ausgebildete programmierbare Verbindung 1, welche mit einem Anschluß an einen Versorgungsspannungsanschluß 16 und mit einem weiteren Anschluß an eine Ansteuerschaltung 2 angeschlossen ist. Die Ansteuerschaltung 2 ist zur Zuführung eines Aktiviersignals B, B' mit einem Schieberegister 3 verbunden. Weiterhin ist ein flüchtiger Speicher 4 vorgesehen, der zum einen zum Auslesen des Zustandes der Antifuse 1 mit dem weiteren Anschluß derselben verbunden ist und zum anderen zur Zuführung eines Datensignals A, A' an einen Dateneingang 11, 12 mit der Ansteuerschaltung 2 verbunden ist.

Die Ansteuerschaltung 2 umfaßt eine UND-Logikschaltung 7, welche Datensignal A, A' und Aktiviersigna B, B' in einer logischen UND-Verknüpfung miteinander verknüpft. Hierfür sind zwei parallelgeschaltete NMOS-Transistoren N1, N2 vorgesehen, von denen ein erster NMOS-Transistor N1 einen Steuereingang aufweist, der an einen Dateneingang 11 angeschlossen ist und ein zweiter NMOS-Transistor N2 einen Steuereingang aufweist, der zur Zuführung des Aktiviersignals B einen Aktiviereingang 14 aufweist. Weiterhin sind zur Zuführung jeweils komplementärer oder inverser Daten- und Aktiviersignale A' ,B' weitere NMOS-Transistoren N3, N4 in der UND-Logikschaltung 7 vorgesehen, welche mit ihren gesteuerten Strecken in Serie geschaltet sind, und von denen ein erster NMOS-Transistor N3 einen Steuereingang aufweist, der an einen Dateneingang 12 angeschlossen ist zur Zuführung des komplementären Datensignals A' und ein zweiter NMOS-Transistor N4 einen Steuereingang aufweist, der mit einem Aktiviereingang 13 zur Zuführung eines komplementären Aktiviersignals B' angeschlossen ist.

Die NMOS-Transistoren N1, N3 mit dem Dateneingang 11, 12 sind zugleich Teil einer Schaltung zur Pegelerhöhung, welche steuerseitig an den Brenntransistor 6 angeschlossen ist. Die Schaltung zur Pegelerhöhung, welche Teil der Ansteuerschaltung 2 ist, weist zwei kreuzgekoppelte PMOS-Transistoren P1, P2 auf, welche über weitere NMOS-Transistoren N5, N6 mit der UND-Logikschaltung 7 verbunden sind. Ausgangsseitig an der Schaltung zur Pegelerhöhung P1, P2, N5, N6 ist ein als PMOS-Transistor ausgeführter Brenntransistor 6 angeschlossen, der mit einem Lastanschluß mit der Antifuse 1 sowie mit dem flüchtigen Speicher 4 zum Auslesen des Zustands der Antifuse 1 verbunden ist.

Der flüchtige Speicher 4 umfaßt eine Speicherzelle 5, welche aus zwei miteinander verbundenen Invertern I1; P3, N7 gebildet ist. Dabei ist ein erster Inverter I1 vorgesehen, an dessen Eingang das Datensignal A ableitbar ist und an dessen Ausgang ein komplementäres oder inverses Datensig A' ableitbar ist. Ein PMOS-Transistor P3 sowie ein NMOS-Transistor N7, deren Steuereingänge miteinander und mit dem Ausgang des ersten Inverters I1 verbunden sind, bilden den zweiten Inverter, dessen Ausgang mit dem Eingang des ersten Inverters I1 verbunden ist. Die Inverter I1 sowie P3, N7 bilden somit als Speicherzelle ein rückgekoppeltes Latch mit Selbsthaltung.

An der Speicherzelle 5 sind zum Zweck des Auslesens des aktuellen Zustands der Antifuse 1 Hilfseingänge 19, 20, 21 vorgesehen. Zunächst wird mit Hilfseingang 19 und einem daran mit seinem Steuereingang angeschlossenen PMOS-Transistor P4 zum Auslesen des Zustands der Antifuse 1 eine logische 1 in die Speicherzelle 5 geschrieben und dort selbstgehalten. Anschließend wird mit Hilfseingängen 20, 21, die zueinander komplementäre CMOS(Complementary Metal-Oxide Semiconductor)-Transistoren P5, N8 der Speicherzelle 5 ansteuern, ein Tristate-Zustand in der Speicherzelle 5 gebildet, welcher die Speicherzelle 5, insbesondere den Inverter P3, N7 hochohmig mit den Versorgungsspannungsanschlüssen 15, 16 verbindet. Zugleich wird ein ebenfalls an Hilfseingang 21 zu seiner Steuerung angeschlossener NMOS-Transistor N9, welcher zwischen einem Anschluß der Antifuse 1 und einem Eingang der Speicherzelle 5 angeschlossen ist, geöffnet. Hierdurch ist bewirkt, daß der Schaltungsknoten am Eingang des ersten Inverters I1 in der Speicherzelle 5 hochohmig bleibt, wenn die Antifuse 1 ebenfalls hochohmig ist, und in einen niederohmigen Zustand übergeht, wenn die als Antifuse ausgebildete Antifuse 1 niederohmig, das heißt bereits geschossen ist. Im letzteren Fall entlädt sich der Eingangsknoten des ersten Inverters I1, welcher das Datensignal A bereitstellt, über Transistor N9 und die in diesem Fall leitende Antifuse 1. Sobald der Zustand der Antifuse 1, das heißt, ob die Antifuse niederohmig leitend oder hochohmig ist, als logische 0 oder 1 in die Speicherzelle 5 ausgelesen ist, werden die hierfür an den Hilfseingängen 20, 21 angelegten Signale entfernt und die Speicherzelle 5 geht wieder in Selbsthaltung über. Mit einem Inverter 12, welcher an den Ausgang des ersten Inverters I1 mit seinem Eingang angeschlossen ist, kann das Datensignal A beziehungsweise das inverse Datensignal A' an einem Ausgang 22 aus Speicherzelle 5 ausgelesen werden. Weiterhin ist die Speicherzelle 5 mit einem Adresseingang ADDR gekoppelt, der eingangsseitig an drei hintereinandergeschalteten Invertern I7, I8, I9 angeschlossen ist. Zur Kopplung des Adresseingangs ADDR mit der Speicherzelle 5 sind weiterhin zwei Paare von NMOS-Transistoren N9, N10; N11, N12 vorgesehen, deren Steuereingänge mit einem Strobe-Eingang STR und mit einem Pointer-Eingang PTR verbunden. Mittels Strobe- und Pointer-Signalen auf den Auswahlleitungen Strobe STR, Pointer PTR kann ein Bit einer Adresse einer Speicherzelle beispielsweise eines SD-RAMs in die Speicherzelle 5 geschrieben werden, wobei die Speicherzelle im SD-RAM, auf die die Adresse zeigt, von der ein Bit am Eingang ADDR zuführbar ist, fehlerhaft sein kann. Ist die Adresse fehlerhaft, so kann mit Auswahlleitungen Strobe, Pointer STR, PTR, welche hierzu aktivierbar sind, das am Adress-Eingang ADDR anliegende Bit der betreffenden fehlerhaften Speicherzellenadresse in die Speicherzelle 5 geschrieben werden.

Mit Speicherzelle 5 kann jedoch, da diese lediglich einen flüchtigen Speicher bildet, keine dauerhafte Speicherung des Bits der Adresse der fehlerhaften Speicherzelle ermöglicht sein. Deshalb ist mit der beschriebenen Ansteuerschaltung 2 das Auslesen der Speicherzelle 5, das heißt des Datensignals A, A' über die bereits beschrieben UND-Steuerlogik 7 sowie das dauerhafte Speichern des ausgelesenen Datums mit dem Brenntransistor 6 in der Antifuse 1 möglich. Die UND-Logikschaltung 7 verknüpft dabei das Datensignal A, A' mit einem Aktiviersignal B, B' in einer UND-Verknüpfung. Folglich wird die Antifuse 1 nur dann gebrannt oder geschossen, wenn sowohl in Speicherzelle 5 eine logische 1 gespeichert ist, als auch zusätzlich am Aktiviereingang 13, 14 eine logische 1 durch das Aktiviersignal B, B' bereitgestellt ist. Schließlich ist für einen Brennvorgang der Antifuse 1 gemäß Ausführungsbeispiel noch erforderlich, daß eine Brennspannung C an den die bereits beschriebene Pegelerhöhungsschaltung bildenden PMOS-Transistoren P1, P2 sowie am Brenntransiste 6 anliegt.

Das Aktviersignal B, B' kann nun gemäß der vorliegenden Erfindung mit dem Schieberegister 3 in der Registerzelle 9 bereit gestellt sein, welche ebenfalls zwei gegengekoppelte Inverter I3, I4 aufweist, welche eine Selbsthalteschaltung bilden. Am Eingang der Registerzelle 9, sowie am Ausgang der Registerzelle 9 ist jeweils ein als PMOS-Transfergate ausgeführter Schalter 8, 10 angeschlossen. Während der eingangsseitig angeschlossene Schalter 8 mit einem ersten Taktsignal CL1, CL1' ansteuerbar ist, kann der ausgangsseitig angeordnete Schalter 10 mit einem zweiten Taktsignal CL2, CL2', welches dem Schalter 10 zuführbar ist, angesteuert werden. Über einen NMOS-Transistor N13, welcher den Eingang der Speicherzelle 9 mit einem Versorgungsspannungsanschluß 16 verbindet, und der steuerseitig an einen Rücksetz-Eingang RES angeschlossen ist, kann der Speicherinhalt der Registerzelle 9 zurückgesetzt werden. Ausgangsseitig an Registerzelle 9 und dem ausgangsseitigen Schalter 10 nachgeschaltet weist das Schieberegister 3 eine weitere Selbsthalteschaltung auf, welche mit zwei ebenfalls gegengekoppelten Invertern I5, I6 realisiert ist und den Schalter 10 mit einem Ausgang 18 des Schieberegisters 3 koppelt. Der Eingang des Schieberegisters 3, welcher an einen Eingang des eingangsseitigen Schalters 8 angeschlossen ist, ist mit 17 bezeichnet.

Wie bereits beschrieben, werden Speicherzellen in SD-RAM-Chips, welche beispielsweise 256 Megabit Speicherplatz haben können, über Adressen selektiert. Eine solche Adresse kann beispielsweise 25 Bit aufweisen. Zur Adressierung einer einzelnen Speicherzelle eines SD-RAM-Chips sind demnach 25 der in der Figur gezeigten Schaltungen, umfassend Antifuse 1, Ansteuerschaltung 2, flüchtiger Speicher 4 und Schieberegister 3 erforderlich. Um beim Brennen der Antifuses 1 jedoch einen unzulässig hohen Stromfluß, welcher kurzzeitig pro Antifuse circa 1 mA betragen kann, zu vermeiden, können die linzelnen Ansteuerschaltungen 2 für die Antifuses 1 mit Schieberegister 3 nacheinander oder teilweise gleichzeitig lektiert oder angesprochen werden. Hierfür können die mehreren Schieberegister 3 in einer Serienschaltung miteinander verbunden sein, wobei jeweils ein Eingang 17 einer Schieberegisterschaltung 3 mit einen Ausgang 18 einer anderen Schieberegisterschaltung 3 verbunden sein kann. Hierdurch ist eine Schieberegisterkette gebildet. Die miteinander über Schalter 8, 10 jeweils verbunden Registerzellen 9 können auch als ein Register aufgefaßt werden. Am Eingang der ersten Registerzelle kann ein Bitmuster-Generator angeschlossen sein, der in vorliegender Figur nicht eingezeichnet ist. Darf lediglich eine Antifuse gleichzeitig gebrannt werden, so ist mit dem Bitmuster-Generator am Eingang der Schieberegisterkette eine Bitfolge bereitstellbar, welche lediglich eine logische 1 aufweist und mit Nullen aufgefüllt wird. Diese logische 1 wird nun nacheinander durch alle Registerzellen 9 des Schieberegisters geschoben, so daß jeweils mit dem jeweiligen Aktiviersignal B nur eine Ansteuerschaltung 2 zur Zeit aktiviert ist. Zur Steuerung des Ablaufes sind die Taktsignale CL1, CL1' und CL2, CL2' vorgesehen. Können mehrere Antifuses 1 gleichzeitig gebrannt werden, so können mit Schieberegister 3 selbstverständlich auch mehrere, unmittelbar aufeinander folgende Einsen oder in einem einstellbaren Abstand durch Nullen beabstandete Einsen durch die Schieberegisterkette geschoben werden.

Die beschriebene Schaltungsanordnung ermöglicht mit dem schnellen, flüchtigen Speicher 4 eine Korrektur fehlerhafter Speicherzellen in einem Massenspeicherchip in Echtzeit. Beispielsweise vor einem Ausschalten des Massenspeicherchip können die jeweiligen Adressen der fehlerhaften Speicherzellen dauerhaft geschrieben werden, wofür die Ansteuerschaltungen 2 und die Antifuse 1 vorgesehen sind. Somit ist ein Brennen von Antifuses 1 zur dauerhaften Speicherung fehlerhafter Adressen, genauer Adressen fehlerhafter Speicherzellen, ermöglicht. Dieses ist auch nach Vergießen und Umhäusen des Massenspeicherchips noch möglich, da die Antifuse 1 elektrisch ansteuerbar ist. Schließlich bietet die Erfindung den Vorteil, daß nicht nur ein unzulässig hoher Brennstrom durch gleichzeitiges Brennen zu vieler Antifuses auftreten kann, sondern daß zudem durch beliebig generierbare und durch die Registerzellen 9 schiebbare Bitmuster eine beliebige Anzahl Antifuses 1 gleichzeitig sowie in beliebiger Reihenfolge gebrannt werden können.

An einen Lese-Eingang RD sind weiterhin die Steueranschlüsse zweier Lesetransistoren R1, R2 angeschlossen. Dabei koppelt die gesteuerte Strecke des ersten Lesetransistors R1 den Eingang der weiteren Speicherzelle I5, I6 des Schieberegisters 3 mit dem Eingang des zweiten Inverters I2 am Ausgang der Speicherzelle 5. Der zweite Lesetransistor R2 koppelt mit seiner gesteuerten Strecke den Ausgang der weiteren Speicherzelle I5, I6 des Schieberegisters 3 mit dem Ausgang des zweiten Inverters I2 und damit dem Ausgang 22 des flüchtigen Speichers 4. Bei Aktivieren der Leseleitung am Lese-Eingang RD können somit in einfacher Weise die in der Speicherzelle 5 gespeicherten Daten beziehungsweise das in Speicherzelle 5 gespeicherte Bit ausgelesen und in das in Selbsthaltung betriebene Latch I5, I6 geschrieben werden. Zur Datenübertragung in umgekehrter Richtung ist an einen Schreib-Eingang WR je ein Steuereingang je eines ersten und zweiten Schreib-Transistors W1, W2 angeschlossen, die ebenso wie die Lesetransistoren R1, R2 als NMOS-Transistoren ausgebildet sind. Dabei koppelt die gesteuerte Strecke des ersten Schreib-Transistors W1 den Eingang der Registerzelle 9 mit einem Eingang der Speicherzelle 5 und der zweite Schreib-Transistor W2 koppelt mit seiner gesteuerten Strecke den Ausgang der Registerzelle 9 des Schieberegisters 3 mit einem Eingang der Speicherzelle 5 im flüchtigen Speicher 4.

Mit den beschriebenen Schreib- und Lese-Transistoren ist in einfacher Weise eine Kopplung zur bidirektionalen Datenübertragung zwischen Speicherzelle 5 und Registerzelle 9, das heißt zwischen flüchtigem Speicher 4 und Schieberegister 3 bewirkt. Bei besonders geringem Flächenbedarg erfüllt das Schieberegister 3 somit eine Doppelfunktion: zum einen ist ein einfaches und schnelles Auslesen und Beschreiben der Speicherzelle 5 möglich, und zum anderen ist mit dem Schieberegister eine Information zum Aktivieren des Brenntransistors 6 zum Brennen der als Antifuse ausgebildeten programmierbaren Verbindung 1 übermittelbar.

### Bezugszeichenliste

- A, A': Datensignal
- ADDR: Adress-Eingang
- B, B': Aktiviersignal
- C: Brennspannung
- CL1, CL1': Taktsignal
- CL2, CL2': Taktsignal
- I1 bis I9: CMOS-Inverter
- N1 bis N13: NMOS-Transistor
- P1 bis P5: PMOS-Transistor
- PTR: Pointer-Eingang
- RD: Lese-Eingang
- WR: Schreib-Eingang
- RES: Rücksetz-Eingang
- R1: Lesetransistor
- R2: Lesetransistor
- STR: Strobe-Eingang
- 1: Programmierbare Verbindung
- 2: Ansteuerschaltung
- 3: Schieberegister
- 4: Flüchtiger Speicher
- 5: Speicherzelle
- 6: Brenntransistor
- 7: Und-Logikschaltung
- 8: Schalter
- 9: Registerzelle
- 10: Schalter
- 11, 12: Dateneingang
- 13, 14: Aktiviereingang
- 15: Versorgungsspannungsanschluß
- 16: Versorgungsspannungsanschluß
- 17: Eingang
- 18: Ausgang
- 19, 20, 21: Hilfseingang
- 22: Ausgang

## Patentansprüche

1. Schaltungsanordnung mit einer Vorrichtung zur Ansteuerung einer programmierbaren Verbindung (1), aufweisend
- eine flüchtige Speicherzelle (5), die mit einem Adreß-Eingang (ADDR) zur Zuführung einer Information vebunden ist,
- die programmierbare Verbindung (1), die mit dem flüchtigen Speicher zur permanenten Speicherung eines Datums aus der flüchtigen Speicherzelle (5) gekoppelt ist und
- ein Schieberegister (3) mit einer Registerzelle (9), welches mit der flüchtigen Speicherzelle (5) zum einen in einer Leserichtung und zum anderen in einer Schreibrichtung zur Datenübertragung zwischen Registerzelle (9) und Speicherzelle (5) gekoppelt ist.

2. Schaltungsanordnung nach Anspruch 1,
**dadurch gekennzeichnet, daß**
ein Schreibtransistor (W1) vorgesehen ist, dessen Steuereingang mit einem Schreib-Eingang (WR) der Schaltungsanordnung verbunden ist und über dessen gesteuerte Strecke die Registerzelle (9) mit der Speicherzelle (5) in Schreibrichtung gekeppelt ist, und daß ein Lesetransistor (R1) vorgesehen ist, dessen Steuereingang an einen Lese-Eingang (RD) der Schaltungsanordnung angeschlossen ist und über dessen gesteuerte Strecke ein Ausgang der Speicherzelle (5) mit dem Schieberegister (3) gekoppelt ist.

3. Schaltungsanordnung nach Anspruch 1 oder 2,
**dadurch gekennzeichnet, daß**
eine Ansteuerschaltung (2) vorgesehen ist zur Ansteuerung der programmierbaren Verbindung (1) mit einem Energieimpuls, wobei die Ansteuerschaltung (2) mit der flüchtigen Speicherzelle (5) zur Übermittlung eines Datensignals (A, A') gekoppelt ist.

4. Schaltungsanordnung nach Anspruch 3,
**dadurch gekennzeichnet, daß**
die Ansteuerschaltung (2) zur Steuerung einer Bereitstellung des Energieimpulses mit dem Schieberegister (3) zur Übermittlung eines Aktiviersignals (B, B') gekoppelt ist.

5. Schaltungsanordnung nach Anspruch 4,
**dadurch gekennzeichnet, daß**
die Ansteuerschaltung eine UND-Logikschaltung (7) aufweist, die einen Dateneingang (11, 12) mit einem Aktiviereingang (13, 14) in einer logischen UND-Verknüpfung verknüpft und die einen Ausgang aufweist, der mit der programmierbaren Verbindung (1) gekoppelt ist.

6. Schaltungsanordnung nach einem der Ansprüche 3 bis 5,
**dadurch gekennzeichnet, daß**
die Ansteuerschaltung (2) einen Brenntransistor (6) aufweist, der eingangsseitig mit der flüchtigen Speicherzelle (5) gekoppelt ist und der an einem Ausgang, der an die programmierbaren Verbindung (1) angeschlossen ist, in Abhängigkeit von Daten- und Aktiviersignal (A, A'; B, B') einen Energieimpuls bereitstellt.

7. Schaltungsanordnung nach einem der Ansprüche 1 bis 6,
**dadurch gekennzeichnet, daß**
das Schieberegister (3) eingangsseitig und ausgangsseitig je einen Schalter (8, 10) aufweist, die zu ihrer Steuerung mit je einem Taktsignal-Eingang (CL1, CL2) verbunden sind.

8. Schaltungsanordnung nach Anspruch 7,
**dadurch gekennzeichnet, daß**
die Schalter (8, 10) im Schieberegister (3) CMOS-Transfergates sind.

9. Schaltungsanordnung nach Anspruch 7 oder 8,
**dadurch gekennzeichnet, daß**
das Schieberegister (3) eine weitere Speicherzelle (15, 16) aufweist, die ausgangsseitig an dem der Registerzelle (9) nachgeschalteten Schalter (10) angeschlossen ist.

10. Schaltungsanordnung nach einem der Ansprüche 1 bis 9,
**dadurch gekennzeichnet, daß**
die Schaltungsanordnung in CMOS-Schaltungstechnik aufgebaut ist.

11. Verwendung zumindest einer Schaltungsanordnung nach einem der Ansprüche 1 bis 10,
in einem Speicherchip zum Ersetzen einer defekten Speicherzelle durch eine redundante Speicherzelle.

## Claims

1. Circuit arrangement having a device for driving a programmable link (1), having
- a volatile memory cell (5), which is connected to an address input (ADDR) for feeding in an information item,
- the programmable link (1), which is coupled to the volatile memory for the permanent storage of a datum from the volatile memory cell (5), and
- a shift register (3) with a register cell (9), which is coupled to the volatile memory cell (5) on the one hand in a read direction and on the other hand in a write direction for data transfer between register cell (9) and memory cell (5).

2. Circuit arrangement according to Claim 1,
**characterized in that**
a write transistor (W1) is provided, whose control input is connected to a write input (WR) of the circuit arrangement and via whose controlled path the register cell (9) is coupled to the memory cell (5) in the write direction, and **in that** a read transistor (R1) is provided, whose control input is connected to a read input (RD) of the circuit arrangement and via whose controlled path an output of the memory cell (5) is coupled to the shift register (3).

3. Circuit arrangement according to Claim 1 or 2,
**characterized in that**
a drive circuit (2) is provided for driving the programmable link (1) with an energy pulse, the drive circuit (2) being coupled to the volatile memory cell (5) for the communication of a data signal (A, A').

4. Circuit arrangement according to Claim 3,
**characterized in that**
the drive circuit (2) for controlling a provision of the energy pulse is coupled to the shift register (3) for the communication of an activation signal (B, B').

5. Circuit arrangement according to Claim 4,
**characterized in that**
the drive circuit has an AND logic circuit (7), which combines a data input (11, 12) with an activation input (13, 14) in a logical AND combination and has an output coupled to the programmable link (1).

6. Circuit arrangement according to one of Claims 3 to 5,
**characterized in that**
the drive circuit (2) has a blowing transistor (6), which, on the input side, is coupled to the volatile memory cell (5) and which, at an output connected to the programmable link (1), provides an energy pulse in a manner dependent on data and activation signal (A, A'; B, B').

7. Circuit arrangement according to one of Claims 1 to 6,
**characterized in that**
the shift register (3) has a respective switch (8, 10) on the input side and on the output side, which switches are connected to a respective clock signal input (CL1, CL2) for their control.

8. Circuit arrangement according to Claim 7,
**characterized in that**
the switches (8, 10) in the shift register (3) are CMOS transfer gates.

9. Circuit arrangement according to Claim 7 or 8,
**characterized in that**
the shift register (3) has a further memory cell (15, 16), which, on the output side, is connected to the switch (10) connected downstream of the register cell (9).

10. Circuit arrangement according to one of Claims 1 to 9,
**characterized in that**
the circuit arrangement is constructed using CMOS circuit technology.

11. Use of at least one circuit arrangement according to one of Claims 1 to 10 in a memory chip for replacing a defective memory cell by a redundant memory cell.

## Revendications

1. Circuit ayant un dispositif pour la commande d'une liaison programmable (1), comportant
- une cellule de mémoire volatile (5), qui est reliée à une entrée d'adresse (ADDR) pour l'amenée d'une information,
- la liaison programmable (1), qui est couplée à la mémoire volatile pour la mémorisation permanente d'une donnée issue de la cellule de mémoire volatile (5), et
- un registre à décalage (3) ayant une cellule de registre (9) qui est couplée à la cellule de mémoire volatile (5) d'une part dans un sens de lecture et d'autre part dans un sens d'écriture pour la transmission de données entre cellule de registre (9) et cellule de mémoire (5).

2. Circuit selon la revendication 1,
**caractérisé par le fait qu'**il est prévu un transistor d'écriture (W1) dont l'entrée de commande est reliée à une entrée d'écriture (WR) du circuit et par l'intermédiaire de la section commandée duquel la cellule de registre (9) est couplée à la cellule de mémoire (5) dans le sens d'écriture et qu'il est prévu un transistor de lecture (R1) dont l'entrée de commande est raccordée à une entrée de lecture (RD) du circuit et par l'intermédiaire de la section commandée duquel une sortie de la cellule de mémoire (5) est couplée au registre à décalage (3).

3. Circuit selon la revendication 1 ou 2,
**caractérisé par le fait qu'**il est prévu un circuit de commande (2) pour la commande de la liaison programmable (1) avec une impulsion d'énergie, le circuit de commande (2) étant couplé à la cellule de mémoire volatile (5) pour la transmission d'un signal de données (A, A').

4. Circuit selon la revendication 3,
**caractérisé par le fait que** le circuit de commande (2) pour la commande de la fourniture de l'impulsion d'énergie est couplé au registre à décalage (3) pour la transmission d'un signal d'activation (B, B').

5. Circuit selon la revendication 4,
**caractérisé par le fait que** le circuit de commande comporte un circuit logique ET (7) qui combine une entrée de données (11, 12) avec une entrée d'activation (13, 14) selon une combinaison ET logique et qui a une sortie qui est couplée à la liaison programmable (1).

6. Circuit selon l'une des revendications 3 à 5,
**caractérisé par le fait que** le circuit de commande (2) comporte un transistor de fusion (6) qui est couplé côté entrée à la cellule de mémoire volatile (5) et qui, en fonction de signaux de données et d'activation (A, A' ; B, B'), fournit une impulsion d'énergie à une sortie qui est raccordée à la liaison programmable (1).

7. Circuit selon l'une des revendications 1 à 6,
**caractérisé par le fait que** le registre à décalage (3) comporte coté entrée et côté sortie à chaque fois un interrupteur (8, 10), lesquels interrupteurs sont reliés pour leur commande à chaque fois à une entrée de signal d'horloge (CL1, CL2).

8. Circuit selon la revendication 7,
**caractérisé par le fait que** les interrupteurs (8, 10) dans le registre à décalage (3) sont des grilles de transfert CMOS.

9. Circuit selon la revendication 7 ou 8,
**caractérisé par le fait que** le registre à décalage (3) comporte une autre cellule de mémoire (15, 16) qui est raccordée côté sortie à l'interrupteur (10) branché du côté aval de la cellule de registre (9).

10. Circuit selon l'une des revendications 1 à 9,
**caractérisé par le fait que** le circuit est construit avec une technique CMOS.

11. Utilisation d'au moins un circuit selon l'une des revendications 1 à 10 dans une puce de mémoire pour remplacer une cellule de mémoire défectueuse par une cellule de mémoire redondante.
